## Europäisches Patentamt

## European Patent Office

## Office européen des brevets

(11) Veröffentlichungsnummer: **0 016 979**
**B1**

(12) **EUROPÄISCHE PATENTSCHRIFT**

(45) Veröffentlichungstag der Patentschrift:
06.07.83

(51) Int. Cl.³: **H 03 H 9/64**

(21) Anmeldenummer: 80101065.3

(22) Anmeldetag: 03.03.80

(54) Akustisches Wellenfilter.

(30) Priorität: 12.03.79 DE 2909705

(43) Veröffentlichungstag der Anmeldung:
15.10.80 Patentblatt 80/21

(45) Bekanntmachung des Hinweises auf die Patenterteilung:
06.07.83 Patentblatt 83/27

(84) Benannte Vertragsstaaten:
AT BE CH FR GB IT NL SE

(56) Entgegenhaltungen:
DE-A-2 132 985
DE-A-2 610 183
DE-A-2 615 719
FR-A-2 265 220
GB-A-1 529 942
US-A-3 550 045
US-A-3 688 223
1973 IEEE ULTRASONICS SYMPOSIUM PROCEE-
DINGS MONTEREY, 5—7 November 1973, New
York, US, A. J. DEVRIES et al.: »A design method
for surface-wave filters using simple structures as
building blocks«, Seiten 441—444

(73) Patentinhaber: SIEMENS AKTIENGESELLSCHAFT,
Berlin und München Wittelsbacherplatz 2,
D-8000 München 2 (DE)

(72) Erfinder: Bulst, Wolf-Eckhart, Dipl.-Phys.,
Arnikastrasse 2, D-8011 Vaterstetten (DE)
Erfinder: Eschler, Hans, Dr.,
Auguste-Viktoria-Strasse 110, D-1000 Berlin 33 (DE)

## Akustisches Wellenfilter

Die vorliegende Erfindung betrifft ein Wellenfilter, wie es im Oberbegriff des Patentanspruchs 1 angegeben ist.

Ein akustisches Oberflächenwellenfilter nach dem Oberbegriff des Patentanspruchs 1 kann eine Laufzeitanordnung mit in einer Richtung in dem Filter laufender Welle oder auch ein Resonator mit in diesem Resonator stehender akustischer Welle sein. Die nachfolgend noch näher zu beschreibende Erfindung ist bei diesen beiden Filtern mit gleichem Erfolg realisierbar.

Aus 1973 IEEE »Ultrasonics Symposium Proc. Monterey«, 5—7 New York, USA, geht eine mathematische Methode zur Bemessung eines Oberflächenwellenfilters hervor, mit dem Ziel die ansonsten bei Anwendung der Fourier-Transformierten auftretenden Fresnel-Rippels zu vermeiden. Es wird hierzu Variation der Fingerabstände innerhalb eines jeweiligen Digitalwandlers angewendet. Für eine Unterdrückung solcher unerwünschter Signale, die auf Reflexionen an Digitalstrukturen des Filters beruhen (tripel transit-Signale) ist nichts angegeben.

Auch die DE-OS 2 610 183, die PS 3 688 223, die US-PS 3 550 045 und die GB-PS 1 529 942 befassen sich mit Beeinflussung des Frequenzganges eines Oberflächenwellenfilters ohne Berücksichtigung möglicher Störsignale, die auf Reflexionen beruhen. Es werden dort Maßnahmen angegeben unter Verwendung gekoppelter, vorzugsweise parallel geschalteter Digitalstrukturen und/oder Resonatoren bestimmte Frequenzgänge mit z. B. entsprechend großer Bandbreite und/oder besonders tiefen Fallen für den Nachbarkanal-Tonträger zu erreichen.

Weiterer technologischer Hintergrund ist in der DE-OS 2 615 719, in der FR-OS 2 265 220 und der DE-OS 2 132 985 enthalten, nämlich die Fingerwichtung wenigstens eines der Digitalwandler zur Dämpfung des Fresnel-Rippels der Übertragungsfunktion bzw. Maßnahmen zur Hervorhebung einer Harmonischen bei gleichzeitiger Unterdrückung der Grundwelle bzw. zur Unterdrückung von Nebenresonanzen weitere Fingerpaare in einer Digitalstruktur vorzusehen, die auf die entsprechenden Nebenresonanzfrequenzen abgestimmt sind.

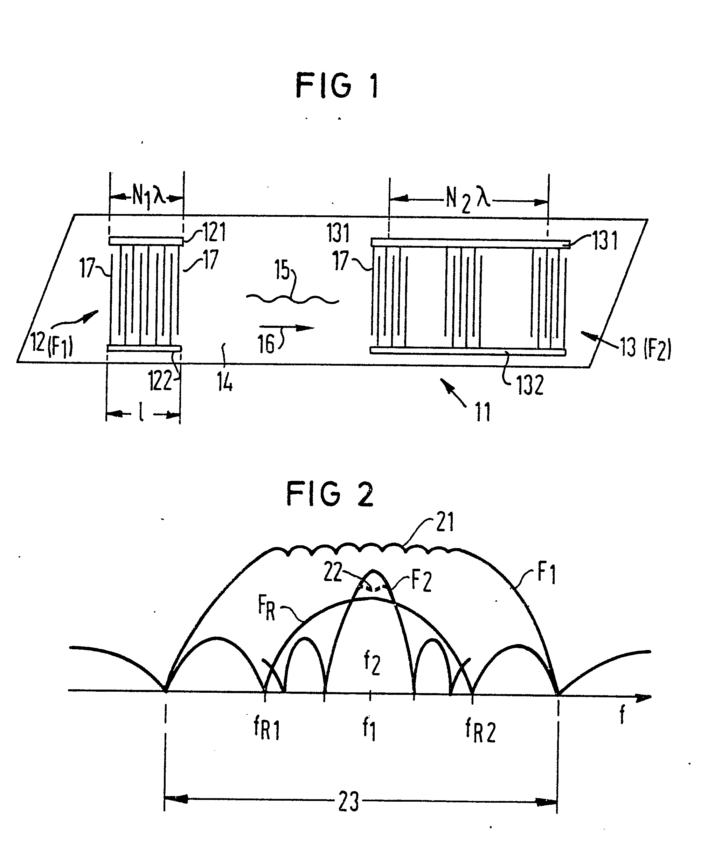

Zum Beispiel ist aus »Electronics Letters«, Bd. 9 (1973), Seiten 195—197, insbesondere aus der Fig. 2, ein 98 MHz-Oszillator bekannt, in dem ein wie bei der vorliegenden Erfindung in Frage kommendes Filter enthalten ist. Dieses Filter umfaßt eine relativ breitbandige Interdigitalstruktur mit einer Länge $N_1 \cdot \lambda$ und eine dazu vergleichsweise schmalbandige Interdigitalstruktur mit einer Länge $N_2 \cdot \lambda$. Diese schmalbandige Interdigitalstruktur ist im übrigen auf ihrer Länge gesehen nicht vollständig mit Digitstreifen bzw. Fingern ausgefüllt, denn dies wäre für die Schmalbandigkeit einerseits nicht erforderlich, bringt andererseits allerdings eine größere Einfügungsdämpfung dieses Filters mit sich. Beide Interdigitalstrukturen haben dieselbe vorgegebene Mittenfrequenz $f_0$. Der Grund dafür, eine (Wandler-)Interdigitalstruktur nicht vollständig mit Digitstreifen auszufüllen, ist der, Signalstörungen durch Reflexionen an einer Interdigitalstruktur des Filters zu vermindern. Solche Reflexionen beruhen z. B. auf von der erwähnten schmalbandigen Struktur $(N_2 \cdot \lambda)$ in Rückwärtsrichtung durch Reflexion ausgehenden Wellen, die auf die erwähnte breitbandige Struktur $(N_1 \cdot \lambda)$ auftreffen, an den Digitstreifen dieser Struktur (wiederum) reflektiert werden und als zeitverzögertes Signal wieder in die schmalbandige Struktur gelangen. Ein dort damit auftretendes Signal wird einschlägig auch als »triple transit«-Signal bezeichnet. Das Auftreten eines solchen Störsignals führt zu einem sogenannten »Rippel« im Amplitudengang $F_0$ des Filters.

Außer der erwähnten Maßnahme nicht vollständige Ausfüllung der einen Wandlerstruktur sind bereits weitere unterschiedlichste Maßnahmen vorgeschlagen bzw. ergriffen worden, ein solches aufgrund unerwünschter Mehrfach-Reflexionen an Interdigitalstrukturen auftretendes (triple transit-)Signal mehr oder weniger zu unterdrücken. Zum Beispiel ist die Maßnahme angewendet worden, die Digitstreifen der einen Struktur in jeweils zwei elektrisch miteinander verbundene Parallelstreifen mit jeweils nur halb so großer Breite aufzuteilen (split fingers). Da aber die maximal zulässige Breite eines Digitstreifens bzw. Fingers von der vorgesehenen Frequenz bzw. Bandmittenfrequenz $f_0$ des Filters mit bestimmt ist, führt die Anwendung des Prinzips der »split fingers« entweder zu extremen Anforderungen bezüglich der Herstellung äußerst schmaler Digitstreifen und/oder zu um $1/2$ verringerter maximaler Frequenz, für die ein einschlägiges Filter ausgelegt werden kann.

Es ist eine Aufgabe der vorliegenden Erfindung, eine Maßnahme zur Unterdrückung solcher Signale, die auf Reflexionen an Digitalstrukturen des Filters beruhen (triple transit-Signale) anzugeben, die ohne zusätzliche technologische Schwierigkeiten zu realisieren sind und/oder unverändert hohe maximale Frequenzen, für die das Filter noch realisierbar ist, zulassen.

Diese Aufgabe wird für ein akustisches Oberflächenwellenfilter nach dem Oberbegriff des Patentanspruchs 1 erfindungsgemäß mit den Merkmalen des Kennzeichens des Patentanspruchs 1 gelöst. Weitere Ausgestaltungen und Weiterbildungen der Erfindung gehen aus den Unteransprüchen hervor.

Zu den mit dem erfindungsgemäßen Filter aufgabengemäß erreichbaren Vorteilen läßt sich zusätzlich bei mit Digitstreifen in stärkerem Maße ausgefüllter Interdigitalstruktur ein Minimalwert der Einfügungsdämpfung erreichen, ohne daß das ansonsten durch einen geringeren Grad der Ausfüllung mehr oder weniger unterdrückte Störsignal auftritt.

Die Erfindung geht von der Erkenntnis bzw. Feststellung aus, daß — wie dies noch näher anhand der Figuren beschrieben werden wird — der Amplitudengang $F_R$ des u. a. auf interdigitalen Reflexionen an der breitbandigeren Digitalstruktur beruhenden (triple transit-)Störsignals unterhalb und oberhalb seiner Mittenfrequenz Null-Stellen $f_{R1}$ und $f_{R2}$ hat. Diese Null-Stellen $f_{R1,2}$ liegen — wie festgestellt wurde — innerhalb des Hauptmaximums des Amplitudengangs $F_1$ der breitbandigeren (Wandler-)Interdigitalstruktur.

Die der Erfindung gemäße Lösung bzw. die erfindungsgemäße Schlußfolgerung aus der voranstehend erörterten Erkenntnis ist, die Mittenfrequenz $f_1$ der Digitalstruktur mit breitbandigerem Amplitudengang $F_1$ um ein Maß $\Delta f$ frequenzmäßig gegenüber der vorgegebenen Mittenfrequenz $f_0$ und damit gegenüber der Mittenfrequenz $f_2$ der schmalbandigeren Digitalstruktur soweit zu verschieben, daß eine der beiden mit der Mittenfrequenz $f_1$ der breitbandigeren Struktur frequenzmäßig gekoppelten Null-Stellen $f_{R1}$ (oder $f_{R2}$) mit dem Frequenzwert $f_0$ des Filters wenigstens weitgehend zusammenfällt. Aufgrund der einem Merkmal der Erfindung entsprechend um ein wenigstens 2faches, insbesondere um wenigstens ein 5faches, geringeren Bandbreite der schmalbandigeren Struktur ist gewährleistet, daß von dem Störsignal ($F_R$) praktisch ein höchstens nur noch geringer Amplitudenanteil in das Übertragungsband ($F_0$) des erfindungsgemäßen Filters fällt.

Weitere Erläuterungen der Erfindung werden anhand der Figuren zu zwei bevorzugten Ausführungsbeispielen der Erfindung beschrieben. Das eine Ausführungsbeispiel betrifft ein erfindungsgemäßes Filter in der Ausgestaltung als schmalbandige Laufzeitleitung und das andere Ausführungsbeispiel zeigt eine Ausgestaltung eines erfindungsgemäßen Filters als Resonator.

Fig. 1 zeigt eine Ausführungsform eines erfindungsgemäßes Filter als Laufzeitleitung,

Fig. 2 zeigt ein Diagramm des Amplitudengangs für ein nach dem Stand der Technik bemessenes Filter,

Fig. 3 zeigt ein Diagramm für ein erfindungsgemäß bemessenes Filter,

Fig. 4 zeigt ein Ausführungsbeispiel eines erfindungsgemäßen Filters als Resonator.

Fig. 1 zeigt eine Ausgestaltung der Erfindung als Laufzeitleitung 11 mit einer ersten Interdigitalstruktur 12 als beispielsweise Eingangswandler und einer zweiten Interdigitalstruktur 13 als Ausgangswandler. Diese beiden Strukturen 12, 13 befinden sich auf einem piezoelektrischen Substratkörper 14 aus beispielsweise Quarz oder Lithiumniobat. Aufgrund ihrer geometrischen Länge $N_2 \cdot \lambda$ hat die Interdigitalstruktur 13 ein relativ schmales Frequenzband bzw. schmalen Frequenzgang $F_2$ mit einer Mittenfrequenz $f_2$. Die einzelnen dargestellten Digitstreifen bzw. Finger der Interdigitalstruktur 12 und 13 sind in der Figur lediglich als Striche 17 wiedergegeben. In der Praxis haben sie z. B. eine Breite von 2 μm, für eine maximale Frequenz von etwa 500 MHz. Die Länge der einzelnen Digitstreifen 17 richtet sich nach der zu übertragenden Signalleistung und kann z. B. 1 mm betragen. Entsprechend dem Aufbau als Interdigitalstruktur 12, 13 sind die Digitstreifen 17 jeweils abwechselnd mit Verbindungsstegen 121, 122 bzw. 131, 132 elektrisch verbunden.

Die Fig. 1 zeigt nur die für die Erfindung wesentlichen Einzelheiten des dargestellten Ausführungsbeispiels eines erfindungsgemäßen Filters, zu dem noch weitere nicht dargestellte Einzelheiten wie Anschlußleitungen, die mit den Verbindungsstegen zu verbinden sind, am Substratende angebrachter akustischer Sumpf und dergleichen, hinzukommen können.

Wird angenommenerweise die Struktur 12 als Eingangswandler verwendet, so läuft die innerhalb dieser Struktur 12 im Substratkörper 14 piezoelektrisch erzeugte akustische Oberflächenwelle (angedeutet mit der Wellenlinie 15) in Pfeilrichtung 16 in den Bereich der Struktur 13 des Ausgangswandlers, um dort wieder in eine elektrische Signalwelle piezoelektrisch zurückumgewandelt zu werden.

Fig. 2 zeigt ein Diagramm mit der Frequenz als Abszisse. Auf der Ordinate sind die Amplituden der Frequenzgänge bzw. Amplitudengänge aufgetragen, und zwar der Amplitudengang $F_1$ für die breitbandige Interdigitalstruktur 12 und der noch näher zu erläuternde Amplitudengang $F_R$ für das Signal der interdigitalen Reflexionen an der breitbandigeren Interdigitalstruktur 12 (triple transit-Signal; TTS). Die frequenzmäßige Zuordnung der Amplitudengänge $F_1$ und $F_2$ zueinander gemäß der Fig. 2 entspricht dem Stand der Technik, nämlich daß die Mittenfrequenz $f_2$ der schmalbandigen Struktur 13 wenigstens im wesentlichen auf der Mittenfrequenz $f_1$ der breitbandigen Struktur liegt. Der sich daraus ergebende Gesamtamplitudengang entspricht aufgrund der Multiplikation der beiden Amplitudengänge $F_1$ und $F_2$ miteinander (mit der für die hier relevanten Betrachtungen ausreichenden Genauigkeit und innerhalb des Hauptmaximums des Amplitudengangs $F_1$) im wesentlichen dem Amplitudengang $F_2$ der schmalbandigen Struktur. Die Mittenfrequenz $f_0$ des gesamten Filters 11 ist somit im wesentlichen gleich der Mittenfrequenz $f_2$ des Amplitudengangs $F_2$. Die dargestellte Welligkeit 21 im Amplitudengang $F_1$ beruht auf seiner Überlagerung mit dem Signal $F_R$ der interdigitalen Reflexionen (TTS-Signal). Diese Welligkeit wird auch als »Rippel« (ripple) bezeichnet. Der Gesamtamplitudengang $F_0$ des Filters 11 erhält auf diese Weise eine wie mit 22 im Amplitudengang $F_2$ gestrichelt angedeutete Störbeeinflussung. In entsprechendem Maß ist ein wie gefordert linearer Phasenverlauf des Filters (über der Frequenz) störend beeinflußt.

Wie festgestellt wurde, ergibt sich für den hier isoliert betrachteten Amplitudengang $F_R$ des Signals der interdigitalen Reflexionen an der (Wandler-)Interdigitalstruktur 12 der mit $F_R$ angegebene Verlauf. Es wurde erkannt, daß die beiden ersten Minima $f_{R1}$ und $f_{R2}$ innerhalb des Hauptmaximums 23 des Amplitudengangs $F_1$ der breitbandigeren Struktur liegen. Wie dargestellt, liegen die Null-Stellen $f_{R1}$ und $f_{R2}$ bei jeweils dem halben Abstand zwischen der Mittenfrequenz $f_1$ des Frequenzgangs $F_1$ und der jeweils ersten Null-Stelle dieses Amplitudengangs $F_1$. Wie ebenfalls festgestellt wurde, hat der Amplitudengang $F_1$ der breitbandigeren Struktur 12 bei diesen Frequenzwerten $f_{R1, 2}$ noch keinen wesentlichen Abfall im Vergleich zur Bandbreite des Amplitudengangs $F_2$ der schmalbandigeren Struktur 13, nämlich wenn — wie für die Anwendungsfälle relevant — das Bandbreiteverhältnis wenigstens etwa 2 : 1 und insbesondere mehr als 5 : 1 beträgt.

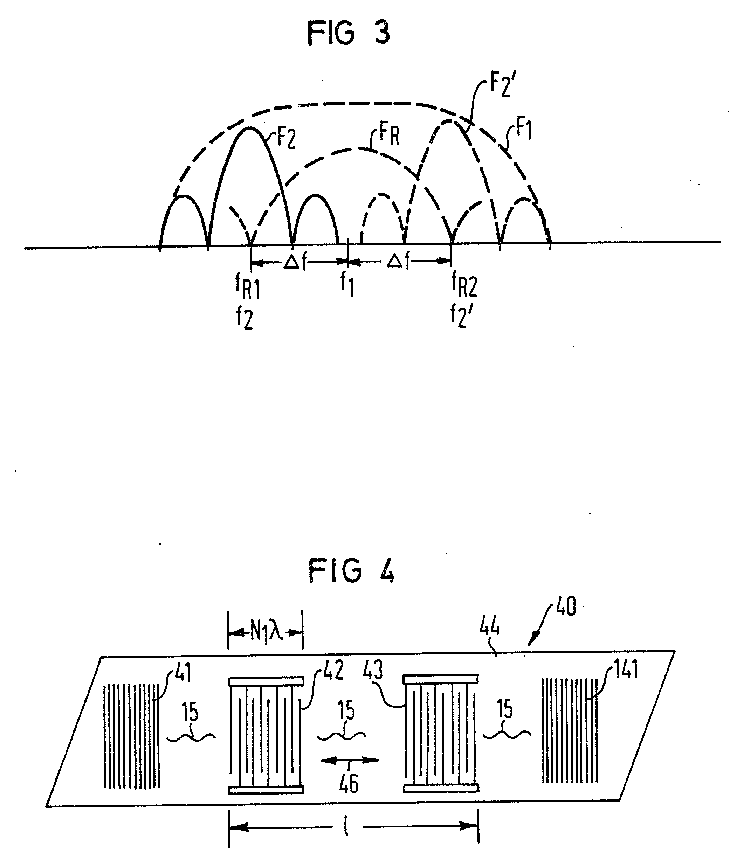

Mit Fig. 3 wird nunmehr der der Erfindung zugrunde liegende wesentliche Gedanke erläutert. Mit $F_R$ ist in Fig. 3 wiederum der Amplitudengang des Signals der interdigitalen Reflexionen an der breitbandigeren Struktur mit seinen Null-Stellen $f_{R1}$ und $f_{R2}$ angegeben. Der Amplitudengang $F_1$ ist hier ohne die in Fig. 2 zum Stand der Technik angegebene, mit der Erfindung jedoch beseitigte Welligkeit 23 des Beispiels wiedergegeben. Entsprechend der erfindungsgemäß vorgesehenen Frequenzverschiebung $\Delta f$ ist der Amplitudengang $F_2$ ($\approx F_0$) der schmalbandigeren Struktur 13 (mit ausgezogener Kurve) mit seiner Mittenfrequenz $f_2$ bei der Frequenz $f_{R1}$ liegend eingetragen. Mit gestrichelter Kurve ist als äquivalente Lösung der Amplitudengang $F_2'$ mit $f_2'$ bei $f_{R2}$ angegeben. Da (für beide Lösungen) nunmehr die eine Null-Stelle von $F_R$ mit der Mittenfrequenz $f_2$ ($f_2'$) der schmalbandigeren Struktur zusammenfällt und außerdem der Amplitudengang $F_1$ über die Breite des Hauptmaximums des Amplitudengangs $F_2$ der schmalbandigeren Struktur 13 noch keinen entscheidenden Amplitudenabfall hat, tritt in dem Gesamt-Amplitudengang $F_0$ entsprechend der der Erfindung zugrunde liegenden Aufgabe nicht mehr diejenige Amplitudenstörung auf, die in der Fig. 2 im Maximum des Amplitudengangs $F_2$ mit 22 gestrichelt angedeutet ist. Der Amplitudengang $F_0$ entspricht für das Hauptmaximum dem quantitativen Verlauf des Amplitudengangs $F_2$ der schmalbandigeren Struktur 13. Die Nebenmaxima haben aufgrund des zur Mittenfrequenz $f_2$ unsymmetrischen Verlaufs des Amplitudengangs $F_1$ eine nicht weiter relevante unsymmetrische Dämpfung.

Phänomenologisch stellt sich die Erfindung somit so dar, daß eine Reflexion einer von der schmalbandigeren Struktur 13 ausgehende akustische Welle an der breitbandigeren Struktur 12 in entscheidendem Maß unterbunden ist. Es tritt somit nunmehr kein störendes triple transit-Signal auf.

Fig. 4 zeigt eine Ausführungsform der Erfindung als Resonator 40. Die Digitstreifen der Strukturen 41 und 141 sowie der Strukturen 42 und 43 befinden sich wiederum auf einem piezoelektrischen Substratkörper 44. Angenommenerweise sei die Interdigitalstruktur 42 der Eingangswandler und die Interdigitalstruktur 43 dazu der Ausgangswandler. Wie beim Beispiel der Fig. 1 können auch hier wiederum Eingangswandler und Ausgangswandler vertauscht sein. Darüber hinaus kann aber beim Resonator nach Fig. 4 ein und dieselbe Interdigitalstruktur 42 oder 43 sowohl Eingangswandler als auch Ausgangswandler sein. Dies ist im wesentlichen eine Frage der peripheren Schaltung des Resonators.

Die in Fig. 4 dargestellten Digitalstrukturen 41 und 141 bilden — in an sich bekannter Weise — zusammengenommen ein Wellen-Reflektorpaar, das für die mit 15 angedeuteten akustischen Wellen dieses Filters einen akustischen Resonator begrenzt. Zwischen dieser beiden einzelnen Digitalstrukturen 41 und 141 bildet sich eine stehende akustische Welle aus, auf die mit dem Doppelpfeil 46 hingewiesen ist. Wie an sich bekannt, ergibt sich die Wellenlänge der im Resonator stehenden Welle, d. h. die der Resonanzfrequenz des Resonators entsprechende Wellenlängengröße, aus der Bemessung der Periodizität der Digitstreifen der beiden Reflektorstrukturen 41 und 141 und dem Abstand der beiden Strukturen 41 und 141 voneinander. Dieser Abstand zusammen mit dem Maß der Reflexionsgüte der beiden Strukturen 41 und 141 ist auch entscheidend für das Maß des Gütewertes des aus diesen Strukturen 41 und 141 gebildeten (passiven) Resonatorhohlraumes. Der reziproke Wert dieser Güte ist das Maß für die relative Bandbreite des Amplitudengangs $F_2$ dieser aus den beiden Digitalstrukturen 41 und 141 gebildeten (Gesamt-)Digitalstruktur des Reflektorpaares. Insbesondere wegen des in der Regel vergleichsweise zu den übrigen Abmessungen der Strukturen großen Abstandes der die Reflektoren bildenden Digitalstrukturen 41 und 141 voneinander bildet dieses Reflektorpaar 41 und 141 die Struktur mit dem schmalbandigeren Amplitudengang $F_2$ (und Phasengang) dieses Resonators. Mit anderen Worten, bei dieser Ausgestaltung eines erfindungsgemäßen Filters als Resonator bilden die zwei Digitalstrukturen 41 und 141 zusammengenommen im Sinne der Formulierung des Patentanspruchs eine einzige Digitalstruktur, bestehend aus jeweils einer Anzahl von Digitstreifen. Diese Wellen-Reflektoren bildenden Strukturen 41 und 141 benötigen bekanntermaßen keinen elektrischen Anschluß. Sie können daher nicht nur als auf der Oberfläche des Substratkörpers 44 aufgebrachte Metallstreifen ausgebildet sein, sondern sie können auch durch entsprechende streifenförmige Oberflächenvertiefungen bzw. Rillen im Substratkörper oder streifenförmige Erhebungen auf der Oberfläche des Substratkörpers realisiert sein.

Dieser Amplitudengang $F_2$ des Reflektorpaares 41, 141 hat die Mittenfrequenz $f_2$. Das Reflektorpaar 41, 141 entspricht hier der schmalbandigeren Digitalstruktur 13 in Fig. 1. Wie bei der Laufzeitleitung nach Fig. 1 bestimmen dieser Amplitudengang $F_2$ und seine Mittenfrequenz $f_2$ wegen der wenigstens 2fach, insbesondere wenigstens 5fach, geringeren Bandbreite (vergleichsweise zum Eingangs- und/oder Ausgangswandler 42 und/oder 43) die Bandbreite $F_0$ und die Mittenfrequenz $f_0$ des gesamten Resonators nach Fig. 4.

Mathematisch ergibt sich für die Erfindung wie folgt:

$$f_1 = \frac{f_0}{1 \pm \dfrac{1}{2\,N_1 - 1}}$$

worin $f_0$ die vorgegebene Mittenfrequenz des Filters ist und $f_1$ die erfindungsgemäß zu wählende Mittenfrequenz der breitbandigeren Digitalstruktur ist. In diesen Formelausdruck geht noch die in Richtung der Wellenausbreitung 16, 46 gemessene Gesamtlänge 1 der breitbandigeren (Wandler-)Digitalstruktur 12 bzw. beim Ausführungsbeispiel des Resonators nach Fig. 4 der beiden Strukturen 42 und 43 zusammengenommen ein. Im letzteren Falle ist die Gesamtlänge 1 vom linksseitigen ersten Digitstreifen der Struktur 42 bis zum letzten rechtsseitigen Digitstreifen der Struktur 43 zugrunde zu legen, da diese beiden Strukturen 42 und 43 zusammengenommen für die interdigitalen Reflexionen des zu beseitigenden Störsignals $F_R$ zusammengenommen wie eine einzige Struktur wirken, die entsprechend dem Zwischenraum zwischen den beiden Strukturen 42 und 43 dort nicht mit Digitstreifen (vollständig) ausgefüllt ist. Für dieses Längenmaß geht die Anzahl $N_1$ der in diese jeweilige Längenabmessung hereinpassenden akustischen Wellenlängen der Oberflächenwelle ein. Für die beiden Vorzeichen + und − erhält man die erfindungsgemäß vorgesehenen Verschiebungen von $f_{R1}$ nach $f_2$ und von $f_{R2}$ nach $f_2$.

Nachdem bei der Erfindung die Störsignale aus ansonsten auftretenden interdigitalen Reflexionen beseitigt sind, können bei einem erfindungsgemäß ausgestatteten Filter Störsignale aus unerwünschten Reflexionen akustischer Wellen an den (in den Figuren) linksseitigen oder rechtsseitigen Kanten des jeweiligen Substratkörpers auftreten. Zur Vermeidung solcher Reflexionen empfiehlt es sich, wie aus den Fig. 1 und 4 ersichtlich, den Substratkörper an den jeweiligen Enden abgeschrägt auszubilden, wie dies speziell für Laufzeitanordnungen (Fig. 1) — jedoch nicht für einen Resonator nach Fig. 4 — üblicherweise praktiziert wird.

## Patentansprüche

1. Wellenfilter mit oberflächennahen akustischen Wellen, mit einem vorgegebenen Amplitudengang $F_0$ und einer vorgegebenen Mittenfrequenz $f_0$ auf piezoelektrischem Substratkörper (11, 40) mit wenigstens zwei Digitalstrukturen (12, 13; 42, 43; 41, 141), die einen Eingangswandler und einen Ausgangswandler sowie gegebenenfalls ein selektives Wellenreflektorpaar (41, 141) enthalten, von denen wenigstens eine Digitalstruktur (12; 42, 43) mit einer Mittenfrequenz $f_1$ einen breitbandigen Amplitudengang $F_1$ und wenigstens eine andere Digitalstruktur (13; 41, 141) mit einer Mittenfrequenz $f_2 \approx f_0$ einen dazu vergleichsweise schmalbandigeren, dem vorgegebenen Amplitudengang $F_0$ entsprechenden Amplitudengang $F_2$ mit $F_2 \approx F_0$ hat, gekennzeichnet dadurch, daß zur Vermeidung von Störungen des Amplituden- und des Phasengangs ($F_0$, $\Phi_0$) durch interdigitale Reflexionen mit einem Störsignal ($F_R$) die breitbandigere ($F_1$) Digitalstruktur ($N_1 \cdot \lambda$; 12; 42, 43) wenigstens 2fach breitbandiger ($N_1 \cdot \lambda \leq {}^1\!/_2\,N_2 \cdot \lambda$) als die schmalbandigere ($F_2$) Digitalstruktur ($N_2 \cdot \lambda$; 13; 41, 141) bemessen ist, und daß für die vorgegebene Mittenfrequenz $f_0 \approx f_2$ die Mittenfrequenz $f_1$ den einen der beiden Werte

$$f_1 = \frac{f_0}{1 \pm \dfrac{1}{2\,N_1 - 1}}$$

hat, worin $N_1$ (Fig. 1) die Anzahl der in die Länge $N_1 \cdot \lambda$ der breitbandigeren ($F_1$) Digitalstruktur (12; 42, 43) hereinpassenden Wellenlängen $\lambda$ der Oberflächenwelle (15) ist.

2. Wellenfilter nach Anspruch 1, gekennzeichnet dadurch, daß der Amplitudengang ($F_1$) der breitbandigeren Digitalstruktur (12; 42, 43) um wenigstens den Faktor 5 breitbandiger als der Amplitudengang ($F_2$) der schmalbandigeren Digitalstruktur (13; 41 und 141) bemessen ist.

3. Wellenfilter als Laufzeitanordnung nach Anspruch 1, gekennzeichnet dadurch, daß nur zwei Digitalstrukturen (12 oder 13) vorgesehen sind, von denen die eine der Eingangswandler ist und die andere Digitalstruktur (13 oder 12) der Ausgangswandler ist.

4. Wellenfilter nach Anspruch 1, gekennzeichnet dadurch, daß die schmalbandigere Digitalstruktur wenigstens weitgehend mit Digitstreifen (17) ausgefüllt ist.

5. Wellenfilter als Resonator nach Anspruch 1 oder 2, gekennzeichnet dadurch, daß die schmalbandigere Digitalstruktur durch ein Reflektorpaar (41, 141) mit jeweils einer Anzahl Digitstreifen gebildet ist, wobei die Bandbreite des schmalbandigen Amplitudengangs ($F_2$) dieses Reflektorpaares (41, 141) durch die Reflektorgüte der das Paar bildenden Reflektoren (41, 141) und den Abstand dieser beiden Reflektoren (41, 141) voneinander gegeben ist (Fig. 4).

6. Wellenfilter nach Anspruch 5, gekennzeichnet dadurch, daß die Digitalstrukturen (42, 43) für den Eingangswandler und für den Ausgangswandler im wesentlichen gleichen Aufbau haben.

7. Wellenfilter nach Anspruch 5, gekennzeichnet dadurch, daß ein und dieselbe breitbandige Interdigitalstruktur (42 oder 43) als Ausgangswandler und als Eingangswandler dient.

## Claims

1. A wave filter having acoustic waves near the surface, with a predetermined frequency response $F_0$ and a predetermined mean frequency $f_0$ on a piezo-electric substrate body (11, 40) having at least two digital structures (12, 13; 42, 43; 41, 141) comprising an input transducer and an output transducer and possibly a selective pair of wave reflectors (41, 141), at least one digital structure (12; 42, 43) having a mean frequency $f_1$ and a wide-band frequency response $F_1$ and at least one other digital structure (13; 41, 141) having a mean frequency $f_2 \approx f_0$ and a narrower-band frequency response $F_2$ with $F_2 \approx F_0$ compared thereto which corresponds to the predetermined frequency response $F_0$, characterised in that in order to avoid distortion of the frequency response and of the phase response ($F_0$, $\Phi_0$) by inter-digital reflections with an distortion signal ($F_R$) the wider-band ($F_1$) digital structure ($N_1 \cdot \lambda$; 12; 42, 43) is dimensioned to have a band-width at least twice ($N_1 \cdot \lambda \leq 1/2\, N_2 \cdot \lambda$) that of the narrower-band ($F_2$) digital structure ($N_2 \cdot \lambda$; 13; 41, 141), and that for the predetermined mean frequency $f_0 \approx f_2$, the mean frequency $f_1$ assumes one of the two values

$$f_1 = \frac{f_0}{1 \pm \dfrac{1}{2\,N_1 - 1}}$$

where $N_1$ (Fig. 1) is the number of the wavelengths of the surface wave (15) which fit into the length $N_1 \cdot \lambda$ of the wider-band ($F_1$) digital structure (12; 42, 43).

2. A wave filter as claimed in Claim 1, characterised in that the frequency response ($F_1$) of the wider-band digital structure (12; 42, 43) has a band-width that is wider than the frequency response ($F_2$) of the narrower-band digital structure (13; 41 and 141) by at least the factor 5.

3. A wave filter as delay line as claimed in Claim 1, characterised in that there are only two digital structures (12 or 13), one being the input transducer and the other is the output transducer.

4. A wave filter as claimed in Claim 1, characterised in that the narrower-band digital structure is at least largely filled with fingers (17).

5. A wave filter as resonator as claimed in Claim 1 or 2, characterised in that the narrower-band digital structure is formed by a pair of reflectors (41, 141) each having a number of finders, where the band width of the narrower-band amplitude response ($F_2$) of this pair of reflectors (41, 141) is represented by the reflector quality of the reflectors (41, 141) which form the pair and by the mutual spacing of these two reflectors (41, 141).

6. A wave filter as claimed in Claim 5, characterised in that the digital structures (42, 43) for the input transducer and for the output transducer have essentially the same construction.

7. A wave filter as claimed in Claim 5, characterised in that the same wider-band interdigital structure (42 or 43) serves both as the output transducer and the input transducer.

## Revendications

1. Filtre d'ondes à ondes acoustiques voisines de la surface, à des amplitudes $F_0$ prédéterminées et à fréquence centrale $f_0$ prédéterminée, sur un corps de substrat piézoélectrique (11, 40) à au moins deux structures digitées (12, 13; 42, 43; 41, 141), qui constituent un transducteur d'entrée et un transducteur de sortie, de même qu'éventuellement une paire sélective de réflecteurs d'ondes (41, 141), dont au moins une structure digitée (12, 42, 43) à fréquence centrale $f_1$ possède une réponse en amplitude $F_1$ à large bande alors que l'autre structure digitée (13, 41, 141) à fréquence centrale $f_2 \approx f_0$ possède une réponse en amplitude $F_2$ correspondant à la réponse en amplitude $F_0$ prédéterminée et comparativement à bande plus étroite, avec $F_2 \approx F_0$, caractérisé par le fait que pour éviter des perturbations de la réponse en amplitude et en phase ($F_0$, $\Phi_0$) par des réflexions interdigitées avec un signal parasite ($F_R$), la structure digitée ($N_1 \cdot \lambda$; 12; 42, 43) à bande plus large ($F_1$) a une largeur de bande qui est au moins 2 fois plus large ($N_1 \cdot \lambda \leq 1/2\, N_2 \cdot \lambda$) que la structure digitée ($N_2 \cdot \lambda$; 13; 41, 141) à bande plus étroite ($F_2$), et que pour la fréquence centrale prédéterminée $f_0 \approx f_2$, la fréquence centrale ($f_1$) a l'une des deux valeurs

$$f_1 = \frac{f_0}{1 \pm \dfrac{1}{2\,N_1 - 1}}$$

$N_1$ (figure 1) est le nombre de longueurs d'onde $\lambda$ de l'onde de surface (15) qui est contenu dans la longueur $N_1 \cdot \lambda$ de la structure digitée (12; 42, 43) à plus grande largeur de bande ($F_1$).

2. Filtre d'ondes selon la revendication 1, caractérisé par le fait que la réponse en amplitude ($F_1$) de la structure digitée à bande la plus large (12; 42, 43) est dimensionnée de manière à avoir une réponse en amplitude 5 fois plus large que la réponse en amplitude ($F_2$) de la structure digitée (13; 41 et 141) à plus petite largeur de bande.

3. Filtre d'ondes constituant une ligne à retard, selon lar revendication 1, caractérisé par le fait que seules deux structures digitées (12 ou 13) sont prévues, dont une est un transducteur d'entrée et l'autre (13 ou 12) le transducteur de sortie.

4. Filtre d'ondes selon la revendication 1, caractérisé par le fait que la structure digitée de plus faible largeur de bande est remplie au moins très largement avec des bandes digitées (17).

5. Filtre à ondes constituant un résonateur, selon la revendication 1 ou 2, caractérisé par le fait que la structure digitée de plus faible largeur de bande est formée par une paire de réflecteurs (41, 141) comportant respectivement un nombre de bandes digitées, la largeur de bande de la réponse en amplitude ($F_2$) de faible largeur de bande de cette paire de réflecteurs (41, 141) étant donnée par le facteur de qualité des réflecteurs qui forment la paire de réflecteurs (41, 141) et par la distance de ces réflecteurs (41, 141) entre eux (figure 4).

6. Filtre d'ondes selon la revendication caractérisé par le fait que les structures digitées (42, 43) sont, pour le transducteur d'entrée et pour le transducteur de sortie, sensiblement de même constitution.

7. Filtre d'ondes selon lar revendication 5, caractérisé par le fait qu'une seule et même structure interdigitée à large bande (42 ou 43) sert de transducteur de sortie et de transducteur d'entrée.

# FIG 1

# FIG 2

# FIG 3

# FIG 4